Europäisches Patentamt

European Patent Office

Office européen des brevets

(11) Numéro de publication: **0 356 299**
**A1**

## (12) DEMANDE DE BREVET EUROPEEN

(21) Numéro de dépôt: **89402240.9**

(22) Date de dépôt: **08.08.89**

(51) Int. Cl.5: **G 01 L 1/22**

(30) Priorité: **16.08.88 FR 8810915**

(43) Date de publication de la demande:
**28.02.90 Bulletin 90/09**

(84) Etats contractants désignés:
**CH DE FR GB IT LI**

(71) Demandeur: **SEDEME**
**11, rue Simonet**
**F-75013 Paris (FR)**

(72) Inventeur: **Marcaillou, François**
**THOMSON-CSF SCPI Cédex 67**
**F-92045 Paris la Défense (FR)**

(74) Mandataire: **Grynwald, Albert et al**
**THOMSON-CSF SCPI**
**F-92045 PARIS LA DEFENSE CEDEX 67 (FR)**

(54) **Capteur à jauge de contrainte à faible sensibilité aux parasites électriques.**

(57) Capteur de déformation présentant un corps d'épreuve (30) en matériau conducteur sur lequel est déposée au moins une jauge de contrainte (31, 31, 33, 34) par l'intermédiaire d'un matériau isolant. Ce capteur est raccordé à un circuit de mesure (40, 43). Il est caractérisé en ce qu'entre la jauge et le corps d'épreuve est interposé un écran conducteur (45) porté à un potentiel déterminé et isolé par rapport au corps d'épreuve et à la jauge. Cet écran élimine les tensions parasites résultant de différences de potentiel $V_p$ entre la référence du circuit de mesure et le corps d'épreuve (30).

FIG_4

Description

## CAPTEUR A JAUGE DE CONTRAINTE A FAIBLE SENSIBILITE AUX PARASITES ELECTRIQUES

L'invention est relative à un capteur à jauge de contrainte.

Pour mesurer les déformations d'une structure mécanique on fait souvent appel à un capteur à jauge(s) de contrainte formé d'un corps d'épreuve faisant partie de la structure, ou lié à elle, sur lequel est déposée ou collée une (ou plusieurs) résistance(s) électrique(s) dont la valeur varie en fonction des déformations subies par ce corps d'épreuve. Le signal fourni par le capteur représente une pression, une force, un déplacement ou une accélération.

Les résistances électriques des jauges de contrainte sont généralement montées en pont de Wheatstone de façon telle que, lorsque le corps d'épreuve se déforme, deux des résistances s'allongent et deux autres raccourcissent.

Etant donné que les déformations du corps d'épreuve sont généralement petites les variations des valeurs des résistances des jauges de contrainte sont faibles. En outre, la tension d'alimentation du pont de Wheatstone ne peut pas présenter une grande valeur (en général de l'ordre de 10 Volts) afin d'éviter un échauffement excessif. De ce fait le signal fourni par un capteur à jauge de contrainte est faible, de l'ordre de 50 millivolts. Il est donc sensible aux parasites électriques.

Pour réduire l'effet des parasites extérieurs sur l'appareil de mesure on utilise généralement des câbles blindés pour raccorder cet appareil à la diagonale de mesure du pont de Wheatstone.

Mais on a constaté que l'utilisation de tels câbles blindés n'éliminait pas tous les parasites.

On a découvert que les principaux signaux perturbateurs, non éliminés par de tels câbles blindés, ont l'origine suivante : en général le corps d'épreuve, habituellement métallique, n'est pas porté au même potentiel que le potentiel de référence, ou masse, du circuit de mesure associé aux jauges de contrainte ; cette différence de potentiel engendre une tension perturbant la mesure par l'intermédiaire des condensateurs que forment les jauges de contrainte, le corps d'épreuve et l'isolant qui sépare ce corps d'épreuve des résistances.

Selon un aspect de l'invention on élimine ces signaux parasites en portant au même potentiel le corps d'épreuve et la référence du circuit de mesure associé aux jauges de contrainte.

Pour éliminer la tension parasite il est également possible d'isoler le corps d'épreuve par rapport à la structure à analyser, c'est-à-dire de le mettre électriquement "en l'air".

Mais ces solutions étant relativement difficiles à mettre en oeuvre, il est préférable, selon un autre aspect de l'invention, de prévoir un écran conducteur entre les jauges de contrainte et le corps d'épreuve, cet écran étant isolé, d'une part, par rapport aux jauges et, d'autre part, par rapport au corps d'épreuve. Cet écran conducteur, en général métallique, est porté à un potentiel constant. De préférence, il est relié par une connexion à faible résistance, au potentiel de référence du circuit de mesure. Si la valeur de la résistance électrique de la connexion au potentiel de référence est nulle l'écran est porté au potentiel de référence du circuit de mesure et ainsi les signaux parasites sont complètement éliminés. Si la résistance de la connexion n'est pas nulle, elle est de toute façon faible et elle constitue avec la capacité du condensateur constitué par l'écran, le corps d'épreuve et l'isolant séparant ces deux éléments, un diviseur de tension tel que le potentiel de l'écran est très peu différent de celui de la référence du circuit de mesure.

Pour augmenter le facteur de division il est préférable que la capacité présentée entre l'écran et le corps d'épreuve ait une faible valeur. De ce fait, dans une réalisation, l'écran a la même forme et les mêmes dimensions que les jauges, ou des dimensions légèrement supérieures de façon qu'il existe une petite largeur d'écran au-delà des bords de chaque jauge.

L'écran doit être suffisamment souple pour ne pas s'opposer à la transmission des déformations du corps d'épreuve vers les jauges de contrainte. Pour augmenter cette souplesse, dans une réalisation, l'écran est constitué de bandes perpendiculaires à la direction de la déformation à mesurer et réunies électriquement entre elles.

D'autres caractéristiques et avantages de l'invention apparaîtront avec la description de certains de ses modes de réalisation, celle-ci étant effectuée en se référant aux dessins ci-annexés sur lesquels :

- les figures 1,2 et 3 sont des vues en perspective de trois modes de réalisation de capteurs avec une seule jauge, et
- la figure 4 est un schéma de connexion d'un capteur à quatre jauges de contrainte montées en pont de Wheatstone.

Un capteur selon l'invention comporte un corps d'épreuve métallique 10 qui est lié à la structure (non représentée) dont on veut déterminer les déformations, représentées ici par des flèches F. En variante, le corps d'épreuve 10 fait partie de la structure déformée à étudier.

Dans l'exemple le corps d'épreuve a une forme générale de parallélépipède rectangle aplati. Toutefois, la forme de ce corps peut être différente.

A la grande face 12 du corps d'épreuve 10 est associée une jauge de contrainte 11 constituée par un fil (ou une bande) résistif à quatre brins $11_1$, $11_2$, $11_2$, $11_3$, $11_4$ parallèles à la direction F de la déformation à mesurer. La fixation de la jauge 11 au corps 10 est telle que les déformations de ce corps 10 sont transmises intégralement, ou dans une grande mesure, au fil de jauge. Bien entendu, le nombre de brins de la jauge 11 est variable selon l'application envisagée ; il peut être compris entre un et plusieurs dizaines.

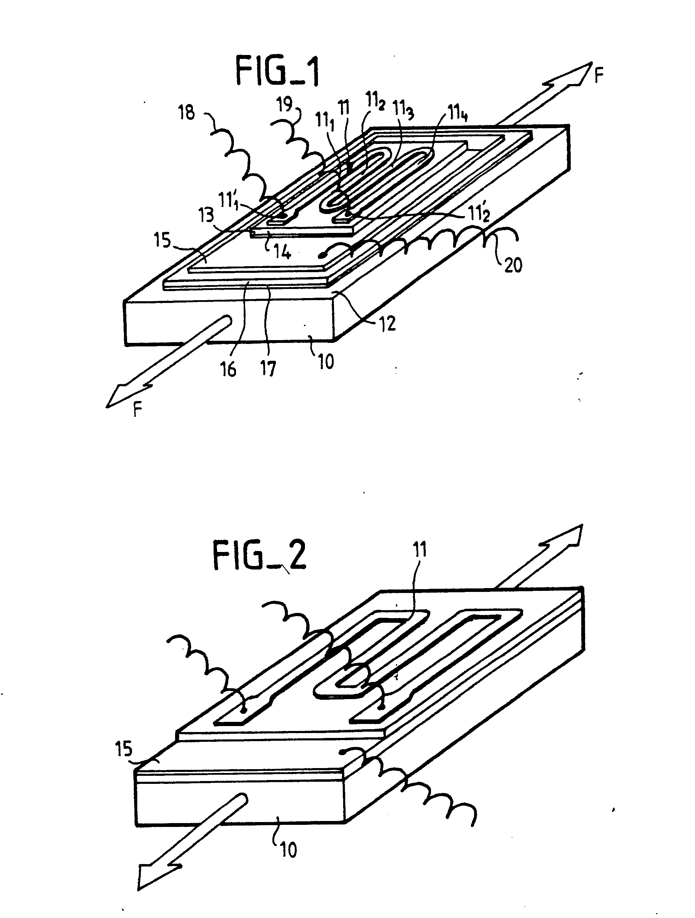

Dans le mode de réalisation représenté sur la figure 1, le fil résistif 11 ainsi que les éléments intermédiaires entre ce fil et la face 12 du corps 10 sont déposés par des techniques de collage.

Le fil 11 est solidaire d'une feuille isolante souple 13 déposée par collage 14 sur une feuille conductrice mince 15 constituant un écran comme expliqué plus loin. La feuille 15, en général métallique, est elle-même solidaire d'une feuille isolante 16 fixée à la face 12 du corps 10 par un collage 17.

Les collages ainsi que les diverses feuilles métalliques et isolantes intermédiaires sont suffisamment souples pour que les déformations du corps 10 soient transmises au fil conducteur 11.

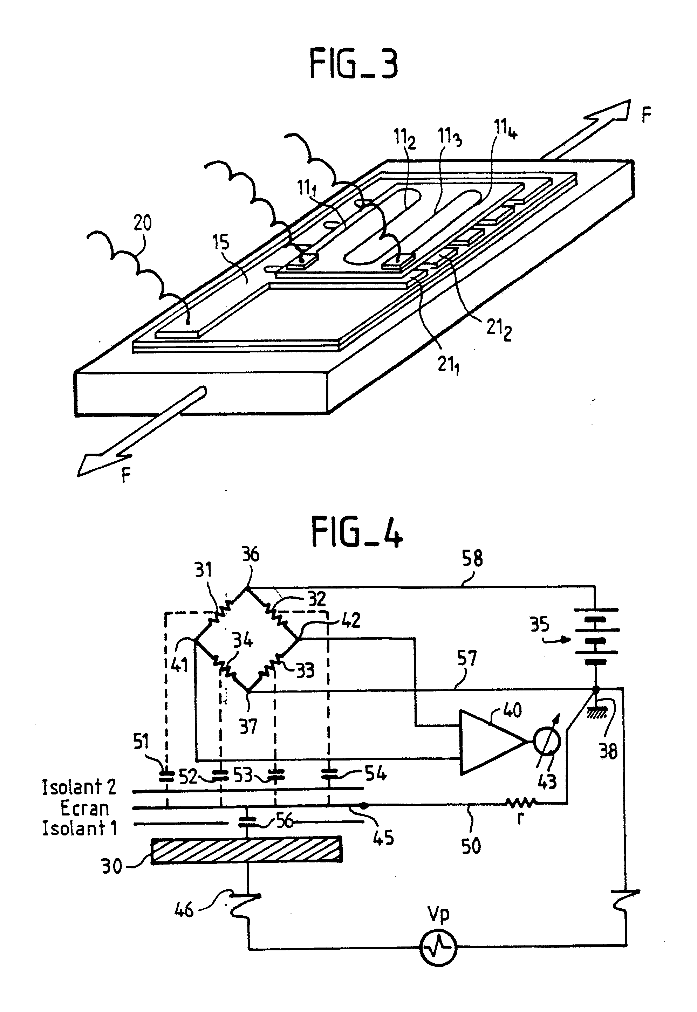

Ce fil 11 présente deux extrémités $11'_1$ et $11'_2$ reliées par des fils conducteurs, respectivement 18 et 19, à un circuit de mesure comme on le verra plus loin en relation avec la figure 4.

La feuille métallique 15 formant écran est associée à un fil conducteur 20, peu résistant, relié à un potentiel fixe comme également décrit plus loin avec la figure 4.

Le capteur représenté sur la figure 2 se distingue de celui décrit en relation avec la figure 1 par le fait, qu'à la place d'une technique de collage, on utilise une technique de dépôt sous vide : évaporation et/ou pulvérisation cathodique. Ce type de capteur est surtout intéressant pour les capteurs fabriqués en grande série et de petites dimensions.

Dans cet exemple la feuille métallique d'écran 15 étant déposée sous vide, elle peut présenter une épaisseur très faible, ce qui est favorable à une grande souplesse et donc à une transmission correcte des déformations du corps d'épreuve 10 vers la jauge de contrainte 11.

Toutefois, dans le premier mode de réalisation (figure 1) il est possible d'utiliser un écran 15 en couche mince préalablement déposée sous vide sur l'isolant 16.

Etant donné que, comme on l'a déjà vu, on a intérêt à minimiser la capacité présentée entre la feuille ou couche 15 et le corps d'épreuve 10, il est préférable de minimiser la surface de l'écran 15. Mais pour que la feuille ou couche 15 ait effectivement un rôle d'écran de préférence cette feuille (ou couche) a, au minimum, une surface qui correspond à celle du fil ou ruban de jauge 11, c'est-à-dire que cet écran 15 a, de préférence, au minimum la même forme et les mêmes dimensions que le fil ou ruban 11.

Pour minimiser la rigidité de l'écran métallique 15, dans une réalisation (figure 3), cet écran est divisé en plusieurs lamelles $21_1$, $21_2$, etc, qui s'étendent perpendiculairement à la direction des brins $11_1$, $11_2$, $11_3$ et $11_4$ du conducteur 11. Les diverses lamelles $21_1$, $21_2$,... sont électriquement reliées entre elles et sont reliées au conducteur 20 connecté à un potentiel fixe. La division en lamelles perpendiculairement à la direction principale selon laquelle s'exercent les contraintes confère une souplesse à l'écran dans cette direction.

Cette séparation en lamelles peut être réalisée par de simples fentes dans une feuille unique.

Cette réalisation est surtout intéressante pour un capteur à feuille métallique 15 massive qui peut présenter une certaine rigidité.

Dans le circuit représenté sur la figure 4 au corps d'épreuve 30, métallique, sont associées quatre jauges de contrainte 31,32,33 et 34 montées selon un pont de Wheatstone.

Ces jauges 31,32,33 et 34 sont associées au corps d'épreuve 30 de la même manière que la jauge 11 au corps d'épreuve 10 dans les réalisations décrites en relation avec les figures 1,2 et 3. Les quatre résistances 31 à 34 sont soit sur un même corps d'épreuve soit sur plusieurs corps d'épreuve.

Une source de tension continue 35 est connectée entre deux bornes 36,37 formant une diagonale du pont de Wheatstone. Cette source fournit une tension d'environ 10 Volts. Elle est reliée à une borne 38 de terre, au potentiel 0 Volt, qui constitue la référence pour l'ensemble du circuit de mesure associé au pont. Dans l'exemple, la borne 38 est connectée à une extrémité de la source 35. En variante, la borne au potentiel de 0 volt constitue le point milieu de la source.

Un amplificateur 40 est aux bornes de l'autre diagonale 41,42 du pont. Cet amplificateur 40 débite dans un appareil de mesure 43

De façon en soi connue c'est la tension entre les bornes 41 et 42 qui donne une indication sur les déformations du corps d'épreuve 30 et donc sur les déformations de la structure auquel il est relié.

Le corps d'épreuve 30 est également relié à une borne 46 d'un potentiel de référence, en général celui de la structure à analyser. Ce potentiel est, dans la plupart des cas, différent du potentiel de référence sur la borne 38 du circuit de mesure. Cette différence de potentiel entre les bornes 38 et 46 est notée Vp sur la figure 4. En l'absence de l'écran métallique 45 cette différence de potentiel induit, par l'intermédiaire des condensateurs formés par chaque résistance, le corps d'épreuve 30 et l'isolant entre les jauges et corps, une tension parasite dans la diagonale de mesure 41,42. Cette tension parasite fausse la mesure des contraintes détectées par le dispositif 43.

Avec l'écran 45 connecté à la borne 38 l'effet de la différence de potentiel Vp est annulé ou rendu négligeable. En effet si la valeur de la résistance du fil conducteur 50 reliant l'écran 45 à la borne 38 est nulle, le potentiel de l'écran 45 est exactement égal au potentiel de référence du circuit de mesure et il n'apparaît ainsi pas de tension parasite dans la diagonale de mesure 41,42 malgré l'existence, inévitable, de condensateurs parasites 51,52,53,54 formés par l'écran 45, chacune des jauges 31,34,33 et 32 et l'isolant entre l'écran et ces jauges.

Si la résistance du conducteur 50 n'est pas nulle mais a une valeur r, de toute façon faible, le potentiel de l'écran 45 est très inférieur au potentiel Vp. Ce potentiel de l'écran 45 est d'autant plus faible que ladite résistance r est petite et que la capacité du condensateur 56 formé par l'écran 45, le corps d'épreuve 30 et l'isolant entre les deux a une petite valeur. C'est pourquoi on rappelle qu'il est préférable, pour minimiser la capacité de ce condensateur parasite inévitable 56, de minimiser la surface de l'écran 45.

De façon générale, il n'est pas indispensable que le potentiel de l'écran 45 soit égal au, ou peu différent du, potentiel de référence du circuit de mesure ; il suffit que ce potentiel de l'écran soit constant et déterminé.

Il n'est pas indispensable non plus que le capteur présente quatre jauges de contrainte connectées suivant un pont. On peut aussi, comme représenté sur les figures 1 à 3, réaliser un capteur ne comportant qu'une seule résistance.

Dans l'exemple décrit en relation avec la figure 4, l'écran 45 est relié directement à la borne 38. La connexion de l'écran 45 au potentiel de référence peut aussi s'effectuer par un fil relié au conducteur 57 d'alimentation reliant la borne 37 du pont à la borne 38 ; il est également possible de connecter l'écran 45 au second fil d'alimentation 58.

## Revendications

1. Capteur de déformation présentant un corps d'épreuve (10 ; 30) en matériau conducteur sur lequel est déposée au moins une jauge de contrainte (11 ; 31,32,33,34) par l'intermédiaire d'un matériau isolant, ce capteur étant raccordé à un circuit de mesure (40,43) associé à la jauge de contrainte, caractérisé en ce qu'entre la jauge et le corps d'épreuve (10 ; 30) est interposé un écran conducteur (15 ; 45) porté à un potentiel déterminé, et isolé par rapport au corps d'épreuve et à la jauge.

2. Capteur selon la revendication 1, caractérisé en ce que l'écran (15,45) est porté au potentiel de référence du circuit de mesure associé à la jauge.

3. Capteur selon la revendication 1, caractérisé en ce que l'écran (15,45) est relié à la borne (38) de référence de potentiel du circuit de mesure par l'intermédiaire d'un conducteur (20 ; 50) à résistance de faible valeur.

4. Capteur selon la revendication 1, caractérisé en ce que l'écran est relié à un potentiel constant par rapport à la référence de potentiel du circuit de mesure par l'intermédiaire d'un conducteur (20, 50) à résistance de faible valeur.

5. Capteur selon la revendication 1, caractérisé en ce que l'écran (15, 45) est relié à un potentiel constant par rapport à la référence de potentiel du circuit de mesure par l'intermédiaire de l'un des deux fils d'alimentation (57, 58) du circuit de mesure.

6. Capteur selon l'une quelconque des revendications précédentes, caractérisé en ce que l'aire de surface de l'écran est égale ou légèrement supérieure à l'aire de la surface de la jauge.

7. Capteur selon l'une quelconque des revendications précédentes, caractérisé en ce que l'écran (15) est divisé en bandes ou lamelles (21$_1$, 21$_2$) s'étendant transversalement à la direction (F) des contraintes à mesurer, les différentes bandes ou lamelles étant toutes portées au même potentiel.

8. Capteur selon l'une quelconque des revendications précédentes, caractérisé en ce qu'il comporte plusieurs jauges de contrainte disposées suivant un montage en pont, notamment un pont de Wheatstone.

9. Capteur selon l'une quelconque des revendications précédentes, caractérisé en ce que écran est constitué par une couche mince.

10. Capteur selon l'une quelconque des revendications 1 à 8, caractérisé en ce que l'écran est formé d'une feuille métallique.

11. Capteur de déformation présentant un corps d'épreuve (10 ; 30) en matériau conducteur sur lequel est déposée au moins une jauge de contrainte (11 ; 31,32,33,34) par l'intermédiaire d'un matériau isolant, ce capteur étant raccordé à un circuit de mesure (40,43) associé à la jauge de contrainte, caractérisé en ce que des moyens (15 ; 45) sont prévus pour empêcher la transmission, vers le circuit de mesure (40,43), de tension parasite résultant d'une différence entre le potentiel du corps d'épreuve (30) et le potentiel de référence dudit circuit de mesure.

12. Capteur de déformation présentant un corps d'épreuve (10,30) en matériau conducteur sur lequel est déposée au moins une jauge de contrainte (11 ; 31,32,33,34) par l'intermédiaire d'un matériau isolant, ce capteur étant raccordé à un circuit de mesure (40,43) associé à la jauge de contrainte, caractérisé en ce que le corps d'épreuve est porté à un potentiel de référence égal au potentiel de référence du circuit de mesure (40,43).

13. Capteur de déformation présentant un corps d'épreuve (10,30) en matériau conducteur sur lequel est déposée au moins une jauge de contrainte (11 ; 31,32,33,34) par l'intermédiaire d'un matériau isolant, ce capteur étant raccordé à un circuit de mesure (40, 43) associé à la jauge de contrainte, caractérisé en ce que le corps d'épreuve est électriquement isolé par rapport à la structure à analyser.

# FIG_1

# FIG_2

# FIG_3

# FIG_4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | DE-A-2 906 669 (BIZERBA-WERKE) <br> * Page 6, lignes 14-22; page 7, lignes 7-11; page 8, lignes 8-11; page 9, lignes 20-24; figures 1-3,6 * <br> ----- | 12-13 | G 01 L 1/22 |

**DOMAINES TECHNIQUES RECHERCHES (Int. Cl.5)**

G 01 L
G 01 R
G 01 G

Le présent rapport a été établi pour toutes les revendications

| Lieu de la recherche | Date d'achèvement de la recherche | Examinateur |
|---|---|---|
| LA HAYE | 25-09-1989 | ZAFIROPOULOS N. |

EPO FORM 1503 03.82 (P0402)